# EUROPÄISCHE PATENTSCHRIFT

(11) **EP 2 308 079 B1**
(45) Veröffentlichungstag und Bekanntmachung des Hinweises auf die Patenterteilung: **21.03.2012**
(21) Anmeldenummer: 09747918.2
(22) Anmeldetag: 18.08.2009
(51) Int. Cl.: H01L 21/00, H01L 21/677, H01L 31/18

(54) **VERFAHREN UND VORRICHTUNG ZUR HERSTELLUNG PHOTOVOLTAISCHER MODULE**
METHOD AND DEVICE FOR PRODUCING PHOTOVOLTAIC MODULES
PROCÉDÉ ET DISPOSITIF DE PRODUCTION DE MODULES PHOTOVOLTAÏQUES

(30) Priorität: 04.08.2008 DE 102008036274
(43) Veröffentlichungstag der Anmeldung: 13.04.2011
(73) Patentinhaber: Grenzebach Maschinenbau GmbH, 86663 Asbach-Bäumenheim (DE)
(72) Erfinder: WEIGL, Helmut, 94315 Straubing (DE)
(74) Vertreter: Kindermann, Peter
(86) Internationale Anmeldenummer: PCT/IB2009/007059
(87) Internationale Veröffentlichungsnummer: WO 2010/015942

(56) Entgegenhaltungen:
- EP-A1- 1 647 532
- EP-B1- 1 298 080
- DE-A1-102004 030 411
- DE-A1-102005 060 452
- JP-A- 6 227 655
- JP-A- 2001 180 822
- JP-A- 2004 153 137
- JP-A- 2007 008 698
- US-A- 4 267 003

## Beschreibung

Die Erfindung betrifft eine Vorrichtung und ein Verfahren zum automatischen Herstellen eines photovoltaischen Moduls, sowie ein Computerprogramm und einen maschinenlesbaren Träger zur Durchführung des Verfahrens.

Moderne Glasfassaden sind vielfach nicht nur ein Funktionselement eines Baukörpers sondern dienen zunehmend auch zur solaren Stromerzeugung. Maßgeschneiderte Solarmodule ermöglichen die passgenaue Integration in Bauwerksraster und Profile. Semitransparente Solarzellen, aber auch opake Solarzellen mit transparenten Bereichen, lassen Photovoltaik - Verglasungen lichtdurchflutet erscheinen. Die Solarzellen übernehmen dabei häufig den gewünschten Effekt des Sonnen - und Blendschutzes.

Die Herstellung von solchen Photovoltaik - Anlagen erfordert Arbeitsbedingungen wie sie vor allem bei der Herstellung von Halbleitern und integrierten elektronischen Schaltungen üblich sind. Die Herstellung photovoltaischer Anlagen ist deshalb noch relativ teuer. Es besteht deshalb das Bestreben die Herstellung photovoltaischer Elemente in großen Serien herzustellen und somit die Kosten zu reduzieren.

Bei einem photovoltaischen Modul handelt es sich, von außen betrachtet, um die Verbindung einer Substratplatte aus Glas, eines photovoltaischen Elements und einer Glasplatte als Deckglas mittels einer, unter Wärmeeinwirkung diese Glasplatten verklebenden, Folie.

Aus der DE 10 2004 030 411 A1 ist ein solches photovoltaisches Element, ein Solarmodul als Verbundsicherheitsglas bekannt geworden. Hierbei werden Solarmodule mit den Eigenschaften von Verbundsicherheitsverglasungen unter Verwendung von Folien auf Basis von Polyvinylbutyral ( PVB ) bereitgestellt, wobei mindestens eine der auf PVB basierenden Folien eine Reißfestigkeit von mindestens 16 N/mm² aufweist. Wie ein solches Element in einer Großserie hergestellt werden soll, ist dieser Druckschrift nicht zu entnehmen.

In dem Dokument JP 2004 153137 A sind eine Vorrichtung und ein Verfahren zum automatischen Zusammenfügen der Bestandteile photovoltaischer Elemente in einem kontinuierlich ablaufenden Fertigungsprozess offenbart, wobei verschiedene Anlagenteile in einer bestimmten Reihenfolge zusammenwirken. Weiter sind hierbei offenbart, eine Fertigungslinie zum taktweisen Anliefern von Substraten, eine Bestückungsbrücke zum Zusammenfügen von Substraten, Folien und Glasscheiben, eine Stapelvorrichtung für eine Folienzuführung, ein Bandförderer zur Glasscheibenzuführung und Vorrichtungen zum Weitertransport der zusammengesetzten photovoltaischen Elemente.

Das Dokument DE 10 2005 060 452 A1 offenbart eine Handhabungsvorrichtung für Flachmaterialien bei der ein Tragrahmen zwischen einer vertikalen und einer horizontalen Position verschwenkbar ist, wobei eine Tragfläche mit evakuierbaren Saugköpfen in einer horizontalen Position wahlweise nach oben oder nach unten weisende Saugköpfe aufweist.

Der vorliegenden Erfindung liegt deshalb die Aufgabe zugrunde, eine Vorrichtung und ein Verfahren sowie ein Computerprogramm und einen maschinenlesbaren Träger zur Durchführung des Verfahrens anzugeben, womit die Herstellung eines photovoltaischen Moduls, das heißt das Zusammenfügen entsprechender Bauteile, automatisch gesteuert, zuverlässig und mit niedrigen Taktzeiten preiswert auf allen Seiten gewährleistet wird. Diese Aufgabe wird hinsichtlich der Vorrichtung durch die Merkmale nach Anspruch 1, hinsichtlich des Verfahrens durch die Maßnahmen nach Anspruch 5, hinsichtlich des Computerprogramms durch die Merkmale des Anspruchs 9 und bezüglich des maschinenlesbaren Trägers durch die Merkmale des Anspruchs 10 gelöst.

In den Unteransprüchen sind weiter vorteilhafte Ausführungsbeispiele der Erfindung gekennzeichnet.

Im Folgenden wird die Erfindung anhand von Figuren näher beschrieben.

Es zeigen im Einzelnen:
- Fig.1:: eine perspektivische Ansicht einer Bestückungsbrücke
- Fig.2:: eine Bestückungsbrücke mit Fertigungslinien
- Fig:3:: eine perspektivische Ansicht der Folienbestückung
- Fig.4:: eine perspektivische Ansicht der Glasbestückung
- Fig.5:: eine Detailansicht einer Zentriervorrichtung
- Fig.6:: eine Darstellung der Folienzentrierung am Stapeltisch
- Fig.7:: eine Darstellung der Zentrierung einer Glasscheibe
- Fig.8:: eine Darstellung der Folienzentrierung am Transport rahmen

Ein photovoltaisches Modul besteht im vorliegenden Fall aus einem so genannten Substrat, das heißt einer Glasplatte mit einer photovoltaisch wirksamen Beschichtung, einer aufgelegten Folie und einer weiteren Glasplatte als Abdeckung, dem so genannten Backglas. Die Folie ist hierbei als eine so genannte Schmelzfolie ausgeführt, die in einem Erhitzungsprozess die Verbindung beider Glasplatten bewirkt.

Diese 3 Elemente werden in der erfindungsgemäßen Vorrichtung zusammengeführt. Auf entsprechenden Fertigungslinien werden bei diesem Vorgang Substrat - Platten herangeführt, die einerseits in abgestimmten Taktzeiten mit einer Folie belegt und andererseits wiederum von einer weiteren Glasplatte abgedeckt werden.

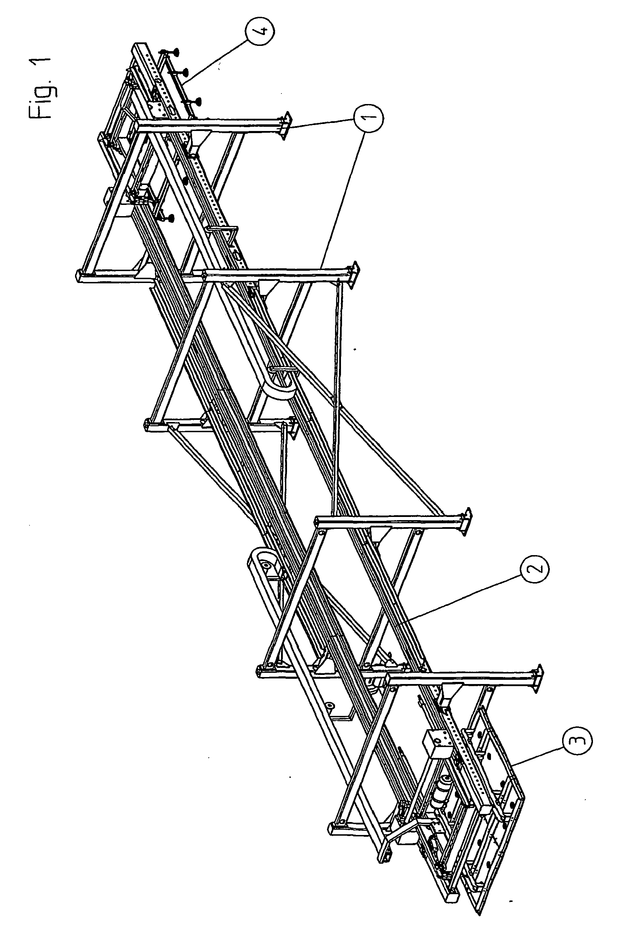

In der Fig.1 ist eine für diesen Zweck entwickelte Bestückungsbrücke in perspektivischer Ansicht dargestellt. Sie besteht im Wesentlichen aus Hauptschienenträgern ( 2 ) die sich auf Portale ( 1 ) abstützen. Am Beispiel der Fig.1 sind lediglich 4 Portale ( 1 ) gezeigt, es können jedoch in der Mitte noch weitere Portale ( 1 ) eingefügt werden wenn die Hauptschienenträger ( 2 ) verlängert werden müssen.

Auf der linken Seite der gezeigten Bestückungsbrücke ist ein Folientransportrahmen ( 3 ) dargestellt, auf der rechten Seite ist ein Glastransportrahmen ( 4 ) zu erkennen.

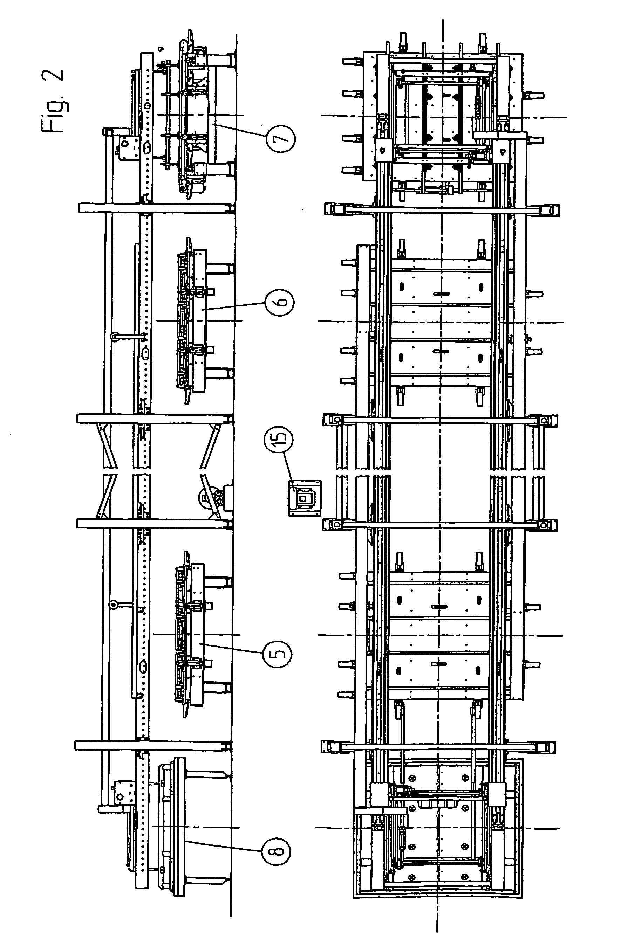

In der Fig.2 ist eine Bestückungsbrücke in der Verbindung mit einer Fertigungslinie 1 ( 5 ) und einer Fertigungslinie 2 ( 6 ) im oberen Teil im Querschnitt, und im unteren Teil in der Draufsicht dargestellt. Der mittlere Bereich beider Teilfiguren ist hierbei unterbrochen gezeichnet um die Möglichkeit aufzuzeigen, an dieser Stelle weitere Fertigungslinien einfügen zu können. Auf der linken Seite ist ein Stapeltisch ( 8 ) für die Folienzuführung gezeigt, während auf der rechten Seite ein Bandförderer ( 7 ) für die Glasscheibenzuführung dargestellt ist. Auf der jeweiligen Fertigungslinie ( 5,6 ) werden die benötigten Substrate, die Glasplatten mit der photovoltaisch wirksamen Beschichtung, angeliefert. Der Vorgang der Zusammenführung eines photovoltaischen Moduls besteht darin, dass auf ein Substrat zuerst eine Folie und dann eine Glasplatte, eine so genannte Backplatte, passgenau aufgebracht werden.

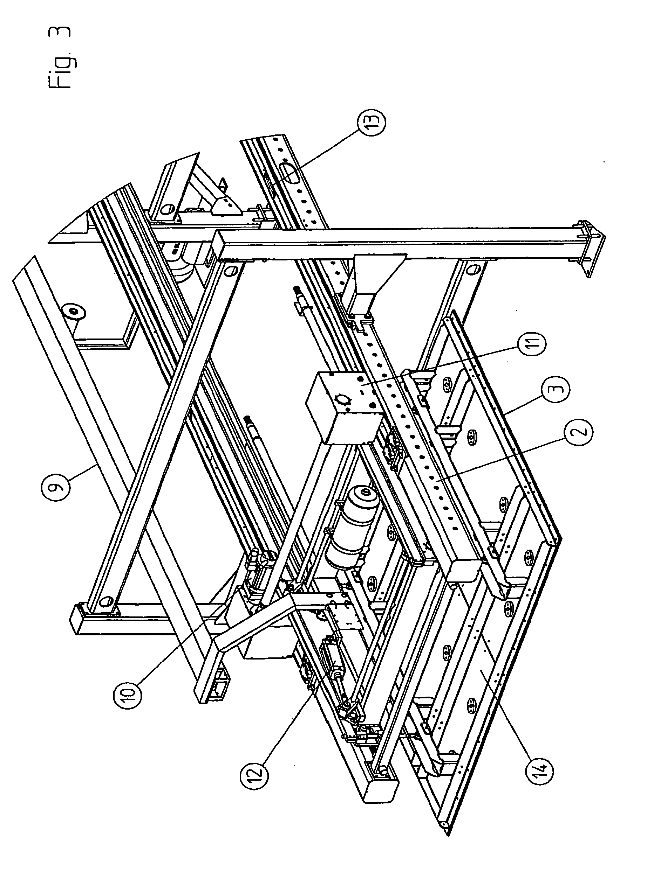

Fig.3 liefert eine perspektivische Ansicht der Folienbestückung. Als Tragvorrichtung für die gesamte Folientransporteinheit sind die in diesem Bereich installierten beiden Portale ( vgl. auch Fig.1 ) mit zwei Hauptschienenträgern ( 2 ) zu erkennen, wobei einer näher bezeichnet ist. Unter den beiden Hauptschienenträgern ( 2 ) hängt der Folientransportrahmen ( 3 ), der mittels des Antriebs ( 12 ) für die Vertikalhubbewegung nach dem Ansaugen einer Folie näher an die beiden Hauptschienenträger ( 2 ) bewegt wird um dann in dieser Höhenlage in den Bereich einer, auf einer Fertigungslinie ( 5,6 ) wartenden, Substratplatte verfahren zu werden. Der Antrieb für diese Bewegung wird durch den Servoantrieb ( 10 ), der auf die beiden Zentriereinrichtungen ( 11 ) wirkt, besorgt. Der Erfassung einer Folie auf dem Stapeltisch ( 8 ) dient der Sensor ( 10 ). Für die Vorgänge der Ansaugung einer Folie, bzw. einer Glasplatte, ist die Unterdruckpumpe ( 15 ) vorgesehen.

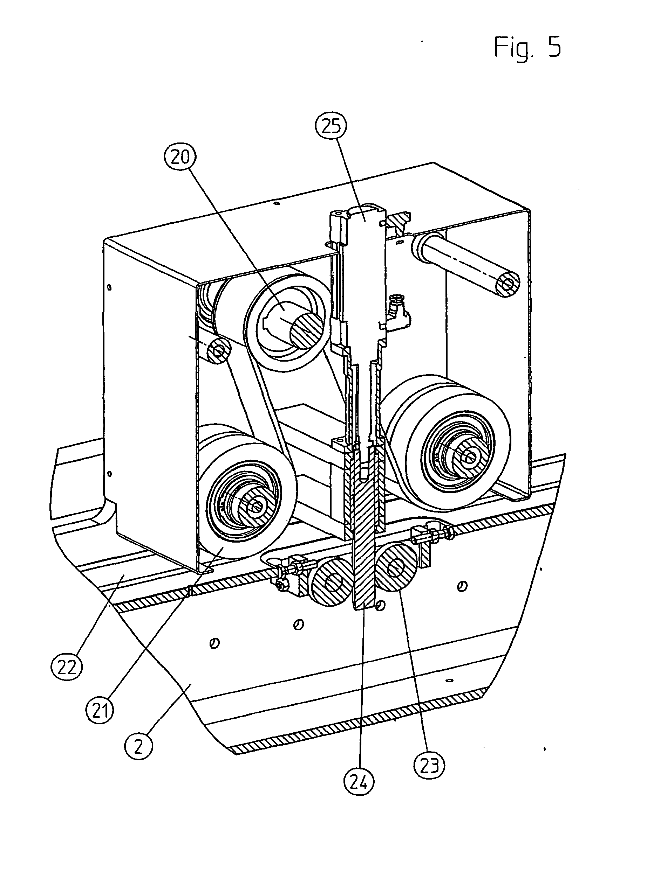

Im Hauptschienenträger ( 2 ) ist in der Fig.3 eine, der paarig angeordneten, Zentrieröffnungen ( 13 ) für einen Zentrierdom, in diesem Fall für die Fertigungslinie 1, gezeichnet. Diese Zentrieröffnungen ( 13 ) dienen der genauen Fixierung des Folientransportrahmens ( 3 ) und gewährleisten ein präzises Absenken einer Folie auf das darunter liegende Substrat wenn der Zentrierdorn des Folientransportrahmes ( 3 ) in dieser Zentrieröffnung ( 13 ) arretiert ist. Den Vorgang des Verfahrens an die betreffenden Stelle im Hauptschienenträger ( 2 ) und das Absenken des Zentrierdorns ( 24 ), ( vgl. auch Fig.5 ), erledigen die Zentriereinrichtungen ( 11 ) die auf beiden Seiten des Folientransportrahmens ( 3 ) angebracht sind. Der Kanal ( 9 ) der über den gesamten Längsbereich einer Brücke verläuft, umfasst alle Zuleitungen und Steuerungsleitungen.

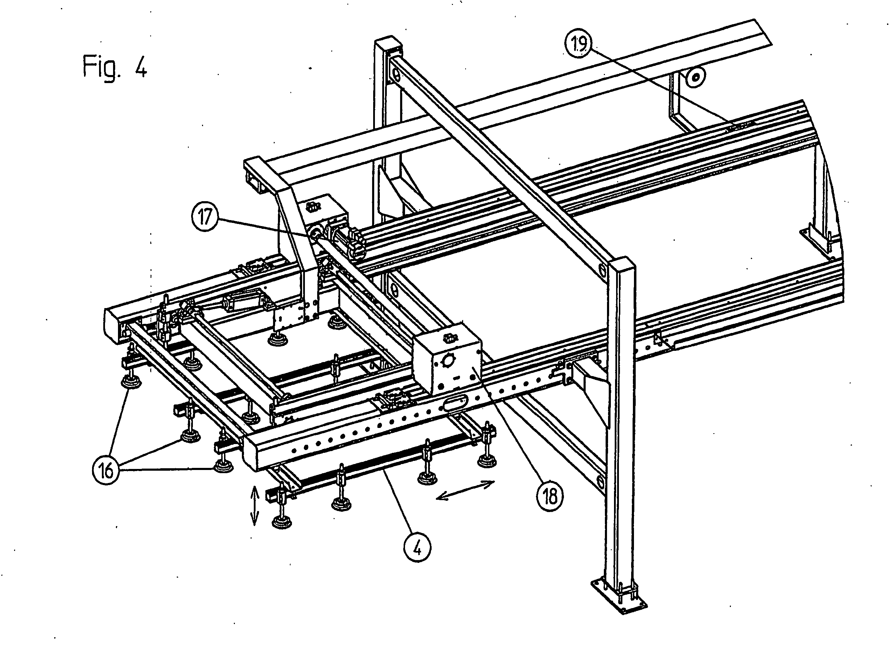

In der Fig.4 ist die, der Folienzufuhr - Einrichtung entsprechende, Einrichtung zur Zuführung der Glasplatten mittels des Glastransportrahmens ( 4 ) dargestellt. Die Lage der mit ( 19 ) bezeichneten Zentrieröffnungen für den Glastransportrahmen ( 4 ) ist lediglich im hinteren Hauptschienenträger ( 2 ) eingezeichnet. Die, den Zentriereinrichtungen ( 11 ) für die Folientransporteinheit entsprechenden, Zentriereinheiten für die Glastransportvorrichtung sind mit ( 18 ) bezeichnet. Der Servoantrieb ( 17 ), der die beiden Zentriereinheiten ( 18 ) antreibt, gewährleistet das Verfahren der gesamten Glastransporteinrichtung zu der entsprechenden Fertigungslinie. Die Unterdrucksauger ( 16 ) dienen dem Anheben und Festhalten der jeweiligen Glasplatte.

Die Detailansicht einer Fixiervorrichtung bietet die Fig.5.

Im unteren Bereich ist hier ein Hauptschienenträger ( 2 ) mit einer entsprechenden Öffnung zur Aufnahme eines Zentrierdorns ( 24 ) zu erkennen. Zur Führung des Zentrierdorns ( 24 ) sind auf beiden Seiten des Dorns Gleitrollen ( 23 ) vorgesehen. Die Halterung und die Absenkung eines Zentrierdorns ( 24 ) wird über einen Hubzylinder ( 25 ) bewirkt. Der Antrieb einer Zentriereinheit erfolgt über die Antriebsachse ( 21 ),die einen Zahnriemen ( 22 ) bewegt der über die Umlenkrollen ( 21 ) geführt wird.

Diese konstruktive Maßnahme kommt in allen 4 betrachteten Zentriereinrichtungen ( 11, 18 ) zum Einsatz und wird wegen der Form der Führung des Zahnriemens Omega - Antrieb genannt.

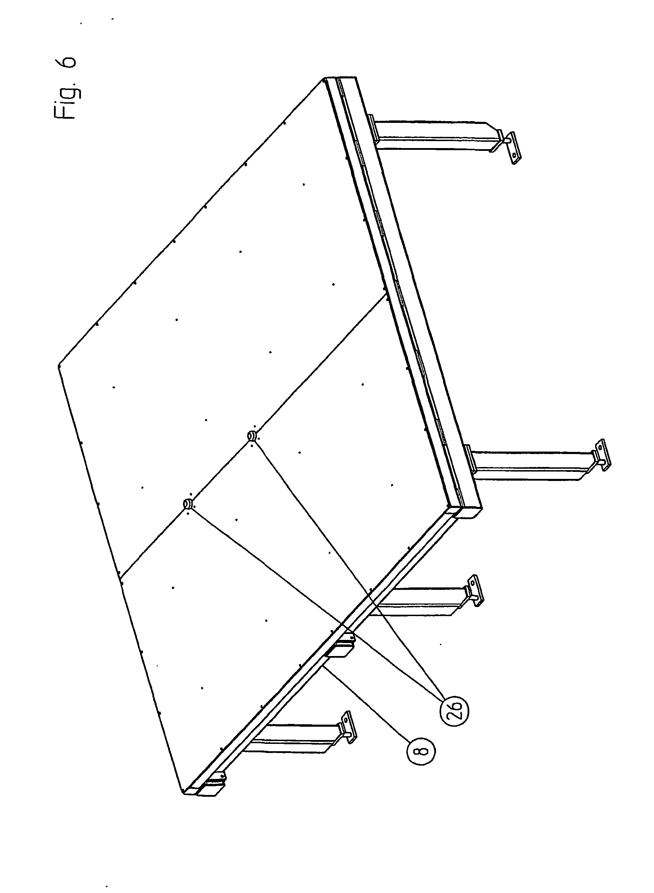

In der Fig.6 ist die Vorzentrierung der aufzubringenden Folien am Stapeltisch ( 8 ) gezeigt. Maßgebend sind hierbei die gezeigten Folienzentrierungen ( 26 ). Zur Zentrierung einer Folie sind jeweils mindestens 2 Folienzentriervorrichtungen ( 26 ) erforderlich. Ihre Anzahl richtet sich hierbei vor allem nach der Größe der aufliegenden Folien. Die Folien können von Hand aufgelegt werden aber auch von einem entsprechend ausgestalteten Roboter einem Magazin entnommen werden.

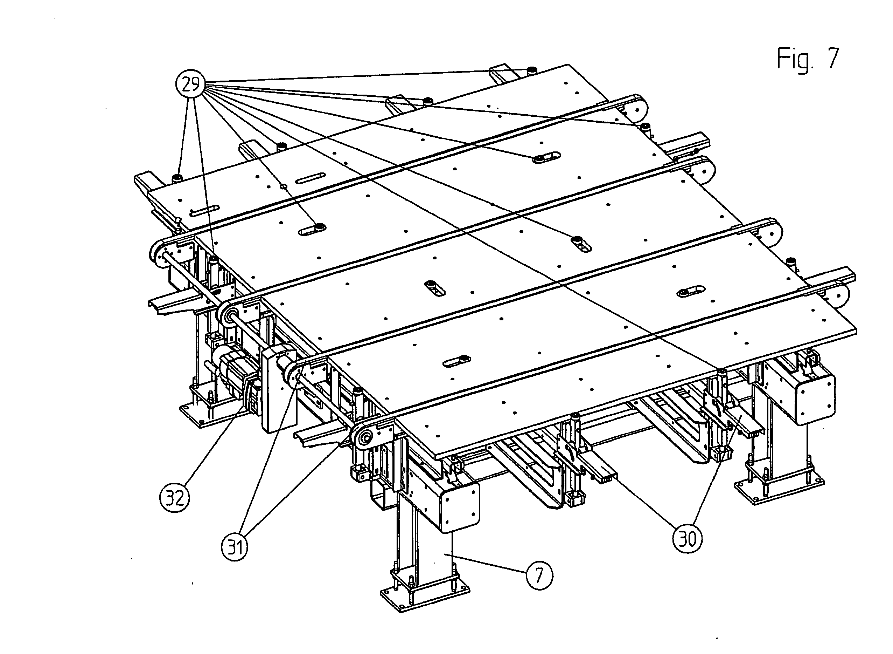

In der Fig. 7 ist die Zentrierung einer Glasscheibe dargestellt.
Über einen Bandförderer ( 7 ) zur Glasscheibenzuführung, mittels der von dem Antrieb ( 32 ) angetriebenen Transportbänder ( 31 ), gelangen die Glasscheiben zu diesem Zentrierbereich. Über die Antriebe ( 30 ) werden hier die Glasplatten mittels der Zentriereinrichtungen ( 29 ) zentriert. Die Vielzahl der gezeigten Zentriereinrichtungen ( 29 ) entspricht der Vielzahl an möglichen Plattenformaten.
In diesem Bereich befindet sich auch eine, nicht gesondert dargestellte, Vorrichtung zur Erkennung defekter Glasplatten. Diese arbeitet, wie dem Fachmann bekannt, auf der Basis optischer Detektoren, und sorgt bei einem Glasfehler dafür dass die betreffende Glasplatte automatisch aussortiert wird. Aus Platzgründen bietet sich hierfür die Aufstellung dieser Zusatzvorrichtung in der Mitte einer Bestückungsbrücke an.

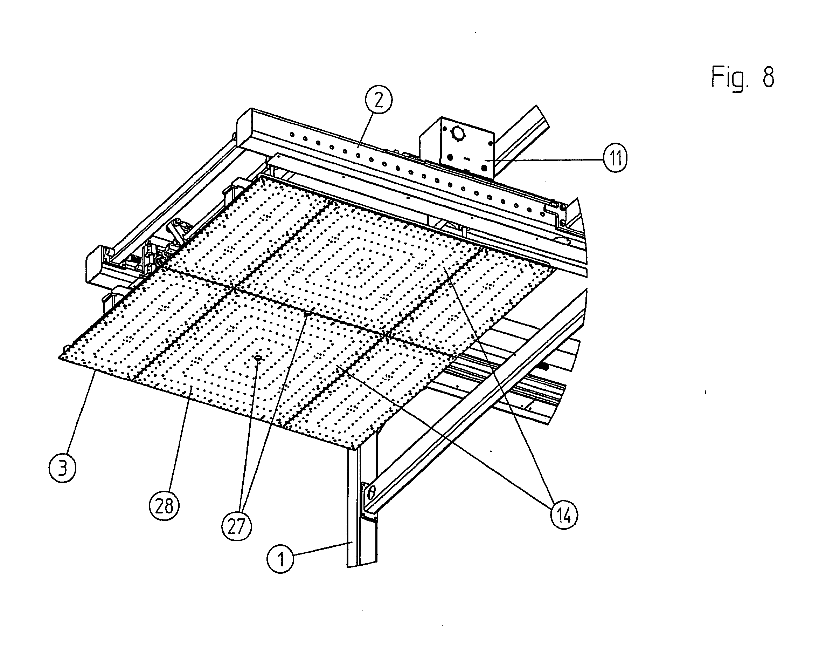

In der Fig.8 ist die Folienzentrierung am Transportrahmen ( 3 ) gezeigt.
Im oberen Bildbereich sind hier die bekannten Hauptschienenträger ( 2 ) und eine Zentriereinrichtung ( 11 ) zu erkennen die am Portal ( 1 ) befestigt sind.
Die beiden Sensoren ( 14 ) dienen der Detektierung des Vorhandenseins einer Folie. Der Zentrierung der Folie am Transportrahmen ( 3 ) dienen die Zentrierelemente ( 27 ),
wobei die gezeigten Saugöffnungen ( 28 ) sinnbildlich für eine ganze Matrix von Saugöffnungen am Folientransportrahmen ( 3 ) stehen, die entsprechend dem Format der jeweiligen Folie aktiviert werden müssen.

Mit der erfindungsgemäßen Vorrichtung ist es möglich nicht nur auf mehreren Fertigungslinien gleichzeitig photovoltaische Elemente herzustellen, sondern die effektive Steuerung und die schnelle und exakte Positionierung aller Bestandteile des Herstellungsprozesses gewährleistet zudem einen Betrieb von mindestens 2 Bestückungsbrücken A und B gleichzeitig.

Da die erfindungsgemäße Vorrichtung die Verarbeitung photovoltaischer Elemente unterschiedlichen Formats erlaubt, sind zur Erfassung dieser unterschiedlichen Formate und der entsprechenden Einstellungen an den Anlagenteilen zahlreiche Sensoren erforderlich die im Einzelnen nicht dargestellt sind.

Für einen störungsfreien Betrieb bei der Herstellung photovoltaischer Elemente bei gleichzeitig hoher Taktzeit und einem variablen Herstellungsprogramm ist ein besonderes Steuerungsprogramm erforderlich.

Eine hohe Taktzeit bedingt eine hohe Verfahrgeschwindigkeit, für die wiederum ein Zahnriemenantrieb vorteilhaft eingesetzt wird. Ein Zahnriemenantrieb weist jedoch eine relativ hohe Positioniertoleranz auf, die aber mittels der erfindungsgemäßen Zentrierungsmaßnahmen reduziert wird.

Eine andere Möglichkeit für eine hohe Verfahrgeschwindigkeit ist die Verwendung von Linearantrieben, die systembedingt eine hohe Positioniergenauigkeit aufweisen. Diese verursachen jedoch deutlich höhere Kosten

### Bezugszeichenliste

- (1): Portale ( Grundrahmen )
- (2): Hauptschienenträger
- (3): Folientransportrahmen
- (4): Glastransportrahmen
- (5): Fertigungslinie 1
- (6): Fertigungslinie 2
- (7): Bandförderer für Glasscheibenzuführung
- (8): Stapeltisch für Folienzuführung
- (9): Zuleitungs- und Steuerleitungskanal
- (10): Servoantrieb für Folientransporteinrichtung
- (11): Omegaantrieb und Zentriereinrichtung für Folientransporteinheit
- (12): Antrieb für Vertikalhubbewegung
- (13): Zentrieröffnung für Zentrierdorn ( Linie 1 )
- (14): Sensor für Foliendetektierung
- (15): Unterdruckpumpe
- (16): Unterdrucksauger
- (17): Servoantrieb für Glastransporteinrichtung
- (18): Omegaantrieb und Zentriereinrichtung für Glastransporteinrichtung
- (19): Zentrieröffnung für Zentrierdorn ( Linie 2 )
- (20): Antrieb ( Zahnriemen )
- (21): Umlenkrollen für Omegaantrieb
- (22): Zahnriemen
- (23): Gleitrollen für Zentrierdorn
- (24): Zentrierdorn
- (25): Hubzylinder für Zentrierdorn
- (26): Folienzentrierung am Stapeltisch
- (27): Folienzentrierung am Saugrahmen
- (28): Saugöffnungen für Folientransportrahmen
- (29): Zentriereinrichtung für Glasscheibe
- (30): Antriebe für Zentriereinrichtung
- (31): Transportbänder
- (32): Antrieb für Transportbänder
- (A): Bestückungsbrücke
- (B): Bestückungsbrücke

## Patentansprüche

1. Vorrichtung zum automatischen Zusammenfügen der Bestandteile photovoltaischer Elemente in einem kontinuierlich ablaufenden Fertigungsprozess, wobei verschiedene Anlagenteile in einer bestimmten Reihenfolge zusammenwirken,
mit den folgenden Merkmalen:
a) mindestens 2 Fertigungslinien ( 5,6 ) zum taktweisen Anliefern von Substraten,
b) mindestens 2 Bestückungsbrücken ( A,B ) zum Zusammenfügen von Substraten, Folien und Glasscheiben,
c) eine Stapelvorrichtung ( 8 ) für eine Folienzuführung und einen Bandförderer ( 7 ) zur Glasscheibenzuführung,
d) Vorrichtungen zum Zentrieren und Ansaugen der Folien ( 8 ) auf einen Folientransportrahmen ( 3 ) sowie zum Zentrieren ( 29,30 ) und Ansaugen der Glasplatten auf einen Glastransportrahmen ( 4 ),
e) Vorrichtungen zum Transport und der Fixierung ( 10,11 ) des Folientransportrahmens ( 3 ) zur betreffenden Fertigungslinie ( 5,6 ),
f) Vorrichtungen zum Transport und der Fixierung ( 17,18 ) des Glastransportrahmens ( 4 ) zur betreffenden Fertigungslinie ( 5,6 ),
g) Vorrichtungen zum Absenken der Folien bzw. der Glasplatten von den jeweiligen Transportrahmen ( 3, 4 ),
h) Vorrichtungen zum Weitertransport der zusammengesetzten photovoltaischen Elemente auf der entsprechenden Fertigungslinie ( 5,6 ).

2. Vorrichtung nach Anspruch 1,
**dadurch gekennzeichnet,**
**dass** Mittel zur Erfassung von fehlerhaften Folien und Glasplatten vorhanden sind, deren Ergebnisse im Fall eines Fehlers zum Ausscheiden des betreffenden Bestandteils führen.

3. Vorrichtung nach Anspruch 1 oder 2,
**dadurch gekennzeichnet,**
**dass** Mittel zur Erfassung unterschiedlicher Formate von Folien und Glasplatten vorhanden sind, deren Parameter bei der Steuerung des Herstellungsprozesses berücksichtigt werden.

4. Vorrichtung nach einem der vorhergehenden Ansprüche,
**dadurch gekennzeichnet,**
**dass** für die Antriebe Servomotoren oder Linearantriebe verwendet werden.

5. Verfahren zum automatischen Zusammenfügen von Substraten, Folien und Glasplatten als Bestandteile photovoltaischer Elemente in einem kontinuierlich ablaufenden Fertigungsprozess,
mit den folgenden Merkmalen:
a) es werden mindestens 2 Fertigungslinien zum taktweisen Anliefern von Substraten eingerichtet,
b) es werden mindestens 2 Bestückungsbrücken (A,B) zum Zusammenfügen der Substrate, Folien und Glasscheiben eingerichtet
c) es wird eine Stapelvorrichtung ( 8 ) für eine Folienzuführung und ein Bandförderer ( 7 ) zur Glasscheibenzuführung vorgesehen,
d) es werden die Folien auf einen Folientransportrahmen ( 3 ) zentriert und angesaugt, und die auf dem Bandförderer ( 7 ) zentrierten Glasplatten auf einen Glastransportrahmen ( 4 ) angesaugt,
e) die Folien und die Glasplatten werden zusammen mit ihren jeweiligen Transportrahmen ( 3, 4 ) zur entsprechenden Fertigungslinie ( 5,6 ) transportiert und dort fixiert,
f) die Folien und Glasplatten werden auf der jeweiligen Fertigungslinie ( 5,6 ) auf die zugehörigen Substrate bzw. Folien abgesenkt,
g) die zusammengesetzten photovoltaischen Elemente werden auf der entsprechenden Fertigungslinie ( 5,6 ) weiter transportiert.

6. Verfahren nach Anspruch 5,
**dadurch gekennzeichnet,**
**dass** Mittel zur Erfassung von fehlerhaften Folien und Glasplatten vorhanden sind, deren Ergebnisse im Fall eines Fehlers zum Ausscheiden des betreffenden Bestandteils führen.

7. Verfahren nach Anspruch 5 oder 6,
**dadurch gekennzeichnet,**
**dass** Mittel zur Erfassung unterschiedlicher Formate von Folien und Glasplatten vorhanden sind, deren Parameter bei der Steuerung des Herstellungsprozesses berücksichtigt werden.

8. Verfahren nach Anspruch 5,6,oder 7
**dadurch gekennzeichnet,**
**dass** für die Antriebe Servomotoren oder Linearantriebe verwendet werden.

9. Computerprogramm mit einem Programmcode zur Durchführung der Verfahrensschritte nach einem der Ansprüche 5 bis 8, wenn das Programm in einem Computer ausgeführt wird.

10. Maschinenlesbarer Träger mit dem Programmcode eines Computerprogramms zur Durchführung des Verfahrens nach einem der Ansprüche 5 bis 8, wenn das Programm in einem Computer ausgeführt wird.

## Claims

1. Apparatus for automatic joining of the components of photovoltaic elements in a continuously running manufacturing process, wherein different installation parts interact in a specific sequence,
having the following features:
a) at least two production lines (5, 6) for clocked delivery of substrates,
b) at least two placement bridges (A, B) for joining substrates, films and glass panes,
c) a stacking apparatus (8) for film supply and a conveyor belt (7) for glass pane supply,
d) apparatuses for centering and sucking the films (8) onto a film transport frame (3), as well as for centering (29, 30) and sucking the glass panes onto a glass transport frame (4),
e) apparatuses for transport and fixing (10, 11) of the film transport frame (3) with respect to the relevant production line (5, 6),
f) apparatuses for transport and fixing (17, 18) of the glass transport frame (4) with respect to the relevant production line (5, 6),
g) apparatuses for lowering the films and the glass panes from the respective transport frames (3, 4),
h) apparatuses for further transport of the joined photovoltaic elements on the corresponding production line (5, 6).

2. Apparatus according to Claim 1, **characterized in that** means are provided for detection of faulty films and glass panes, whose results lead to segregation of the relevant component in the event of a fault.

3. Apparatus according to Claim 1 or 2, **characterized in that** means are provided for detection of different formats of films and glass panes, whose parameters are taken into account for the control of the production process.

4. Apparatus according to one of the preceding claims, **characterized in that** servo motors or linear drives are used for the drives.

5. Method for automatic joining of substrates, films and glass panes as components of photovoltaic elements in a continuously running manufacturing process,
having the following features:
a) at least two production lines are designed for clocked delivery of substrates,
b) at least two placement bridges (A, B) are designed for joining the substrates, films and glass panes,
c) a stacking apparatus (8) is provided for film supply, and a conveyor belt (7) is provided for glass pane supply,
d) the films are centered and sucked onto a film transport frame (3), and the glass panes, which have been centered on the conveyor belt (7) are sucked onto a glass transport frame (4),
e) the films and the glass panes are transported together with their respective transport frames (3, 4) to the corresponding production line (5, 6), and are fixed there,
f) the films and glass panes are lowered onto the associated substrates or films on the respective production line (5, 6),
g) the joined photovoltaic elements are transported further on the corresponding production line (5, 6).

6. Method according to Claim 5, **characterized in that** means are provided for detection of faulty films and glass panes, whose results lead to segregation of the relevant component in the event of a fault.

7. Method according to Claim 5 or 6, **characterized in that** means are provided for detection of different formats of films and glass panes, whose parameters are taken into account for the control of the production process.

8. Method according to Claim 5, 6 or 7, **characterized in that** servo motors or linear drives are used for the drives.

9. Computer program having a program code for carrying out the method steps according to one of Claims 5 to 8 when the program is run on a computer.

10. Machine-legible storage medium having the program code of a computer program for carrying out the method according to one of Claims 5 to 8 when the program is run on a computer.

## Revendications

1. Dispositif de jonction automatique de composants d'éléments photovoltaïques dans un processus de fabrication en continu, dans lequel différentes parties de l'installation coopèrent dans une séquence définie, le dispositif présentant les caractéristiques suivantes :
a) au moins 2 lignes de fabrication (5, 6) qui délivrent des substrats de manière cadencée,
b) au moins 2 ponts d'assemblage (A, B) qui réunissent des substrats, des films et des vitres,
c) un dispositif d'empilement (8) qui amène un film et un transporteur à bande (7) qui amène des vitres,
d) des dispositifs de centrage et d'aspiration des films (8) sur un bâti (3) de transport de film ainsi que de centrage (29, 30) et d'aspiration des plaques de verre sur un bâti (4) de transport de verre,
e) des dispositifs de transport et de fixation (10, 11) du bâti (3) de transport de film vers la ligne de fabrication (5, 6) concernée,
f) des dispositifs de transport et de fixation (17, 18) du bâti (4) de transport de verre vers la ligne de fabrication (5, 6) concernée,
g) des dispositifs d'abaissement des films ou des feuilles depuis leur bâti de transport (3, 4) respectif et
h) des dispositifs de poursuite du transport des éléments photovoltaïques assemblés sur la ligne de fabrication (5, 6) concernée.

2. Dispositif selon la revendication 1, **caractérisé en ce qu'**il présente des moyens de saisie des films et des plaques de verre défectueux, dont les résultats entraînent en cas de défaut la mise à l'écart du composant concerné.

3. Dispositif selon les revendications 1 ou 2, **caractérisé en ce qu'**il présente des moyens de détection des différents formats de films et de plaques de verre dont les paramètres sont pris en compte dans la commande du processus de fabrication.

4. Dispositif selon l'une des revendications précédentes, **caractérisé en ce qu'**il utilise des servomoteurs ou des entraînements linéaires pour les entraînements.

5. Procédé de jonction automatique de substrats, de films et de plaques de verre qui constituent des composants d'éléments photovoltaïques dans un processus de fabrication en continu,
le procédé comportant les caractéristiques suivantes :
a) au moins 2 lignes de fabrication sont prévues pour délivrer des substrats de manière cadencée,
b) au moins 2 ponts d'assemblage (A, B) sont prévus pour assembler les substrats, les films et les vitres,
c) un dispositif d'empilement (8) est prévu pour amener des films et un transporteur à bande (7) pour amener les vitres,
d) les films sont centrés et aspirés sur un bâti (3) de transport de film et les plaques de verre centrées sur le transporteur à bande (7) sont aspirées sur un bâti (4) de transport de verre,
e) les films et les plaques de verre sont transportés en même temps que leurs bâtis de transport (3, 4) respectifs vers la ligne de fabrication (5, 6) concernée et y sont fixés,
f) les films et les plaques de verre sont abaissés sur les substrats ou films associés sur la ligne de fabrication (5, 6) concernée et
g) les éléments photovoltaïques assemblés sont transportés plus loin sur la ligne de fabrication (5, 6) concernée.

6. Procédé selon la revendication 5, **caractérisé en ce qu'**il présente des moyens de saisie des films et des plaques de verre défectueux, dont le résultat en cas d'erreur conduit à la mise à l'écart du composant concerné.

7. Procédé selon les revendications 5 ou 6, **caractérisé en ce qu'**il présente des moyens de détection des différents formats de films et de plaques de verre dont les paramètres sont pris en compte dans la commande du processus de fabrication.

8. Procédé selon les revendications 5, 6 ou 7, **caractérisé en ce que** des servomoteurs ou des entraînements linéaires sont utilisés pour les entraînements.

9. Programme informatique contenant un code de programme permettant d'exécuter les étapes de procédé selon l'une des revendications 5 à 8 lorsque le programme est exécuté sur un ordinateur.

10. Support lisible par machine et présentant le code de programme d'un programme informatique permettant d'exécuter le procédé selon l'une des revendications 5 à 8 lorsque le programme est exécuté sur un ordinateur.
